(19) Europäisches Patentamt
European Patent Office
Office européen des brevets

(11) **EP 3 276 368 A1**

(12) **EUROPEAN PATENT APPLICATION**

(43) Date of publication:
**31.01.2018 Bulletin 2018/05**

(51) Int Cl.:
**G01R 33/561** (2006.01)  **G01R 33/48** (2006.01)
**G01R 33/565** (2006.01)  **G01R 33/50** (2006.01)

(21) Application number: **16181003.1**

(22) Date of filing: **25.07.2016**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(71) Applicants:
• **Universite d'Aix-Marseille (AMU)**
**13284 Marseille Cedex 07 (FR)**
• **CNRS (Centre National De Recherche Scientifique)**
**75794 Paris Cedex 16 (FR)**

(72) Inventor: **RAPACCHI, Stanislas**
**13012 MARSEILLE (FR)**

(74) Representative: **Macquet, Christophe**
**Macquet & Associés**
**Arche des Dolines**
**7, rue Soutrane**
**06560 Sophia Antipolis (FR)**

(54) **METHOD FOR OBTAINING A FREQUENCY-RESOLVED BALANCED STEADY-STATE FREE PRECESSION IMAGE SERIES**

(57) The invention relates to a method for obtaining a set of frequency-sensitive balanced steady-state free precession images. The method according to the invention comprises the steps of: providing radio-frequency excitation pulses, wherein the phase of said excitation pulses $\phi_{bSSFP}$ is incremented so that its derivative divided by $2\pi$ is periodic, its fundamental period $M$ is a non-null integer, and its peak-to-peak amplitude is equal to $\frac{1}{TR}$, wherein $TR$ is the balanced steady-state free precession repetition time; acquiring steady-state free precession signals; and reconstructing each balanced steady-state free precession image using a combination of k-spaces samples acquired every **M** repetition time.

FIG. 1

Printed by Jouve, 75001 PARIS (FR)

**Description**

FIELD OF THE INVENTION

The invention relates to a method for obtaining a frequency-resolved balanced steady-state free precession image series.

BACKGROUND OF THE INVENTION

In Magnetic Resonance Imaging (MRI) and Nuclear Magnetic Resonance (NMR) spectroscopy, spins resonate at various frequencies depending on their electromagnetic environment. As a consequence, the metabolites exhibit different nuclear magnetic resonance frequencies, but also the presence of electromagnetic interferences such as metal, paramagnetic molecules like oxygen or even temperature change the resonant frequency of local spins. Various techniques enable the discrimination of frequencies in MRI, but a compromise between frequency resolution and spatial resolution is necessary. In Magnetic Resonance Spectroscopy Imaging (MRSI), to resolve the entire spectrum, spatial resolution is typically limited to the scale of centimeters and acquisitions spans at least 10 minutes. In Chemical Exchange Saturation Transfer (CEST) imaging, spatial resolution scales in millimeters but only a single metabolite can be targeted and the acquisition still spans over 10 minutes. Finally, in fat-water imaging such as Dixon techniques, the spectrum is discretized to few frequencies that are fixed so that high spatial resolution is achieved with rapid acquisitions on the order of a minute for a slice.

During the past years, balanced Steady-State Free Precession (bSSFP) has found widespread use in clinical applications including cardiac imaging, angiography, gastrointestinal imaging, and imaging of the musculo-skeletal system. The main advantages of bSSFP are its high signal-to-noise ratio (SNR) and its short acquisition time. However, bSSFP is rather sensitive to inhomogeneities in the main magnetic field, which appear as dark bands at specific off-resonance frequencies. As a result, image quality in bSSFP imaging can be degraded severely due to the banding artefacts caused by these inhomogeneities.

To avoid these so-called banding artefacts, proper shimming and short repetition times (TR) are usually applied. While these measures are sufficient for rather low local field variations, banding often remains when moving to higher field strengths or when imaging regions close to large susceptibility differences. Also, the necessity for a sufficiently short TR limits the maximum achievable resolution.

Phase-cycled bSSFP is a more sophisticated approach to overcome these constraints. To obtain an image with reduced or no residual banding artefacts, several bSSFP images with different radiofrequency (RF) phase increments between subsequent RF-pulses are acquired and combined. Various algorithms for the combination of the phase-cycled images have been proposed but the underlying principle is always the separate acquisition of multiple images. Thus, this approach requires a long scan time.

The publication document entitled "Dynamically Phase-Cycled Radial Balanced SSFP Imaging for Efficient Banding Removal", T. Benkert et al., Magnetic Resonance in Medicine, 73:182-194, 2015 discloses a method for banding removal in bSSFP imaging. According to this method, the phase-cycle during single-shot radial acquisition of an image is dynamically changed. Thus, each projection is acquired with a different frequency offset. Using conventional radial gridding, an artefact-free image is then reconstructed out of this dataset. However, in order to guarantee the banding removal, numerous radial acquisitions have to be carried out, the quality of the reconstructed image may still be improved and more importantly the spatially-resolved frequency information is lost.

SUMMARY OF THE INVENTION

Accordingly, a need exists for obtaining magnetic resonance images of high resolution that discriminate frequency, which are reliable, even if they are acquired in a very short period of time. All the while, balanced steady-state free precession images have high resolution, high signal-to-noise ratio, can be acquired rapidly and exhibit a clear sensitivity to frequency.

In accordance with a first aspect, the invention concerns a method for obtaining a set of frequency-sensitive balanced steady-state free precession images comprising the steps of:

> providing radio-frequency excitation pulses, wherein the phase of said excitation pulses $\phi_{bSSFP}$ is incremented so that its derivative divided by $2\pi$ is periodic, its fundamental period $M$ is a non-null integer, and its peak-to-peak amplitude is equal to $\frac{1}{TR}$, wherein $TR$ is the balanced steady-state free precession repetition time;
> acquiring steady-state free precession signals; and

reconstructing each balanced steady-state free precession image using a combination of k-spaces samples acquired every M repetition time.

Preferentially, - the radio-frequency excitation pulses are incremented continuously using a quadratic phase increment $\phi_i$, according to the following equation: $\phi_{bSSFP}(n) = \phi_i n^2$ wherein n is the count number of each balanced steady-state free precession signal during steady-state and $M = \dfrac{\pi}{\phi_i}$ ; the frequency response in the acquired steady-state free precession signals is varying every repetition time according to the following equation: $f_{bssFP}(n) = \dfrac{\phi_i n}{\pi TR}$ modulo $\dfrac{1}{TR}$ wherein $f_{bSSFP}$ is the central frequency of the frequency response and n is the count number of each balanced steady-state free precession signal during steady-state; - the combination of the k-spaces samples is synchronous to the radio-frequency pulses phase variation so that an image series is a set of $\boldsymbol{M = \dfrac{\pi}{\phi_i}}$ images; - multiple bSSFP acquisitions with different repetition time TR are carried out and combined to resolve the entire spectrum; - the resolution of the entire spectrum is provided by the following equation: $f_{bSSFP}(n, TR) = FSF_{bSSFP}(n, TR) * f_{true}$ wherein $f_{bSSFP}(n, TR)$ is the $n$ out of $M$ reconstructed frequency images for a given acquisition of TR, $FSF_{bSSFP}(n,TR)$ is the frequency spread function response of the sequence for this given image, which includes the balanced steady-state free precession frequency wrapping characterized by $f_{wrap}(TR) = 1/TR$, and $f_{true}$ is the entire frequency content; - the entire frequency content $f_{true}$ is resolved using the following equations:

$$\begin{bmatrix} f_{bSSFP}(n \in M_1, TR_1) \\ \vdots \\ f_{bSSFP}(n \in M_k, TR_k) \end{bmatrix} = \begin{bmatrix} FSF_{bSSFP}(n \in M_1, TR_1) \\ \vdots \\ FSF_{bSSFP}(n \in M_k, TR_k) \end{bmatrix} * f_{true} \leftrightarrow f_{alias} = A_k * f_{true}$$

wherein $k$ is the number of acquisitions with different TR values. The vector $f_{alias}$ contains all frequency signals, but with 1/TR aliasing, for one pixel in the image, and the matrix $A_k$ contains all frequency responses for all M frequency-resolved images and for all k acquisitions; - the variations of the static magnetic field B0 are corrected; - the inhomogeneities in the magnetic field B1 are corrected; and - the relaxation properties T1 and T2 are resolved.

In accordance with a second aspect, the invention concerns a computer-readable medium including a set of instructions for executing the previous method, by means of an electronic calculator.

BRIEF DESCRIPTION OF THE DRAWINGS

Other features and aspects of the present invention will be apparent from the following description and the accompanying drawings, in which:

Fig. 1 shows a simulated signal of a bSSFP experiment for a quadratic phase increment of $\phi_i$=0.5 deg. according to the invention;
Fig. 2 shows the repetition of an acquisition according to the invention, with a different repetition time;
Fig. 3 represents the processing pipeline according to the invention; and
Fig. 4 illustrates the results of a 4-TR "Prismatic" MRI experiment according to the invention.

DETAILED DESCRIPTION OF THE INVENTION

The invention concerns a method for obtaining a set of frequency-sensitive balanced steady-state free precession (bSSFP) images. This is an *in vivo* non-invasive method that allows to obtain reliable images of the composition of biological tissues of the human or animal body within a very short period of time, and with a high resolution, through 2D/3D/time-resolved MRI. The method also allows to determine the features of these tissues that are influencing their electromagnetic properties such as temperature, metallic environment and/or oxygenation. The method according to the invention also allows to obtain reliable frequency-resolved signals of biological tissues, through NMR spectroscopy, *in vitro.*

In bSSFP, as in SSFP, each type of gradient-echo (GE) sequence consists of a train of excitation pulses that are separated by a repetition time (TR). The acquisition and the spatial Fourier encoding of the GE is performed between consecutive excitation pulses by means of switched gradient pulses along read, phase, and slice direction. The effect of excitation and gradient pulses on a single magnetization vector can be described by the Bloch equation. An excitation pulse is modelled as a rotation of the magnetization vector by a certain angle, the flip angle, whereas dephasing, induced by gradient pulses or other field inhomogeneities, is equivalent to a rotation around the z-axis (axis along B0). The amount of dephasing within a TR depends on the spatial position and on the gradient strength and duration. In addition to these rotations, T1 and T2 relaxations occur during TR. T1 relaxation results in a small increase of the longitudinal component of the magnetization vector, and T2 relaxation provides a shortening of the transverse part. After one TR, the next excitation pulse acts on the modified magnetization, and the process of rotation and relaxation is repeated again and again. Under certain conditions, a steady state of the magnetization is established after several TR periods. This is the steady-state free precession (SSFP). Different gradient time courses produce different spatially dependent dephasings within TR, which finally results in different types of steady states, and more importantly, in different image contrasts. bSSFP is a special type of SSFP sequence where the gradient-induced dephasing within TR is exactly zero. In other words, within TR, each applied gradient pulse is compensated by a gradient pulse with opposite polarity. This makes the pictorial description of the evolving magnetization from excitation pulse to excitation pulse simple and concise.

The method according to the invention comprises the step of providing radio-frequency excitation pulses, wherein the phase of said excitation pulses providing radio-frequency excitation pulses, wherein the phase of said excitation pulses $\phi_{bSSFP}$ is dynamically incremented so that its derivative, i.e. the frequency sweep, is M periodic, such that M is non-null integer, and its peak-to-peak amplitude is equal to $\frac{1}{TR}$, M is the frequency sweep cycle length and $TR$ is the balanced steady-state free precession repetition time. One implementation is to use a quadratic phase increment $\phi_i$ and define $M = \frac{\pi}{\phi_i}$ an integer to produce a saw-tooth periodic frequency response. It allows the frequency response of the sequence to vary every repetition time (TR) as the derivative of the phase. Preferentially, a quadratic phase increment is implemented, that provides a linear variation of the frequency response. However, any phase variation which is non-linear (order of increment equal to 1) can be defined to shape the frequency response to desired frequency sweep, as long as the time derivative of the phase variation remains periodic in frequency according to a period integer M and peak-to-peak amplitude of 1/TR.

When a quadratic phase increment is implemented, the phase of the radio-frequency excitation pulse $n$, and the central frequency and the bSSFP response are as follows:

$$\phi_{bSSFP}(n) = \phi_i n^2 \rightarrow f_{bSSFP}(n) = \frac{\phi_i n}{\pi TR}$$

where $n$ is the count number of each bSSFP signal during steady-state, $\phi_{bSSFP}$ is the phase of the radiofrequency (RF) excitation pulse, $\phi_i$ is the quadratic phase increment, $f_{bSSFP}$ is the central frequency of the bSSFP frequency response and $TR$ is the repetition time of the sequence.

The spectral resolution is thus defined by the phase increment and the repetition time at the time of acquisition.

However, the bSSFP frequency horizon remains cyclic every 1/TR. Indeed:

$$f_{bSSFP}(n) = \frac{\phi_i n}{\pi TR}, modulo(\frac{1}{TR})$$

According to another further step of the invention balanced steady-state free precession signals are acquired. These signals are acquired using a MRI scanner.

According to a further step of the invention, in combination with the quadratic phase increment, a combination of k-space lines is carried out, such that k-space samples acquired every $M = \frac{\pi}{\phi_i}$ are combined in one image:

$$f_{bSSFP}(n_1) = f_{bSSFP}\left(n_{1+\frac{\pi}{\phi_i}}\right) = \cdots = f_{bSSFP}\left(n_{1+k\frac{\pi}{\phi_i}}\right)$$

and a total of $M = \frac{\pi}{\phi_i}$ images with different frequency content is reconstructed, $\frac{\pi}{\phi_i}$ being an integer.

The frequency spectrum is thus decomposed as a prism would decompose the light.

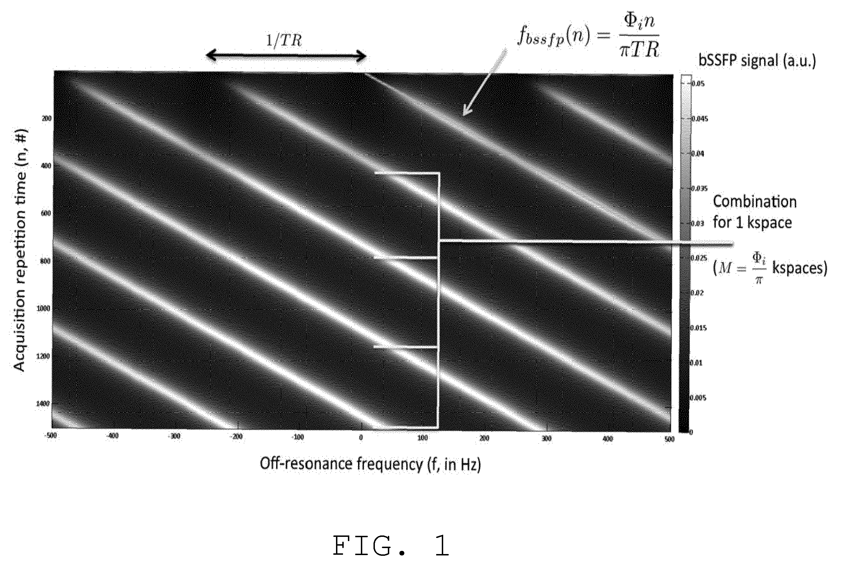

Fig. 1 shows a simulated signal of a balanced SSFP experiment for a quadratic phase increment of $\phi_i$=0.5 deg, (TE/TR=2/4ms, alpha=40 deg., T2/T1=10/1000ms). The quadratic phase variation shifts the frequency response linearly according to the equation $f_{bSSFP}(n) = \frac{\phi_i n}{\pi TR}$. The frequency response presents a cyclic aliasing every 1/TR. MRI signals every $M = \frac{\pi}{\phi_i}$ repetition time have identical frequency profiles and are combined to form a single k-space, and thus a single image, for a total of M k-spaces.

The combination of k-space samples is synchronous to the phase cycling, and the k-space sampling can be freely chosen to provide a sufficient k-space coverage.

The k-space sampling can be also synchronous. The sequence acquires M identically localized $kx_1$ lines, then moves to a new k-space line for M repetition times, etc.

The k-space sampling can be asynchronous, either random or according to Cartesian, radial or spiral sampling with steps defined by the golden ratio. The signals occurring every M repetition times are still combined into M different k-spaces. The asynchronous sampling facilitates retrospective synchronization to an additional temporal phenomenon. The k-space samples can be redistributed according to both their "prismatic" frequency position and their time along a motion dimension, for example, a cardiac and/or respiratory cycle.

The proposed construction of k-spaces is compatible with multiple sampling strategies: Cartesian, radial or spiral and multiple dimensions: 2D, 3D and time, as well as any under-sampling technique and its reconstruction counterpart: partial Fourier, parallel imaging and Compressed Sensing.

Additionally, in order to resolve the entire spectrum, multiple bSSFP acquisitions, for example 3 to 6, with different TR to provide a different frequency response for each experiment, are acquired and combined. The resolution of the spectrum becomes an inverse problem stated as follows:

$$f_{bSSFP}(n, TR) = FSF_{bSSFP}(n, TR) * f_{true}$$

where $f_{bSSFP}(n,TR)$ is the $n$ out of M reconstructed frequency images for a given acquisition of TR, $FSF_{bSSFP}(n,TR)$ is the Frequency Spread Function (FSF) response of the sequence for this given image and $f_{true}$ is the entire "true" frequency content. FSF can be defined numerically using Bloch equations simulations. The library of FSF can be declined: for multiple B1+ to resolve B1 +, for multiple compartments with magnetization transfer (MT) exchanges and/or chemical saturation transfer (CEST) using Bloch-McConnell equations and for a range of relaxation parameters T1 and T2.

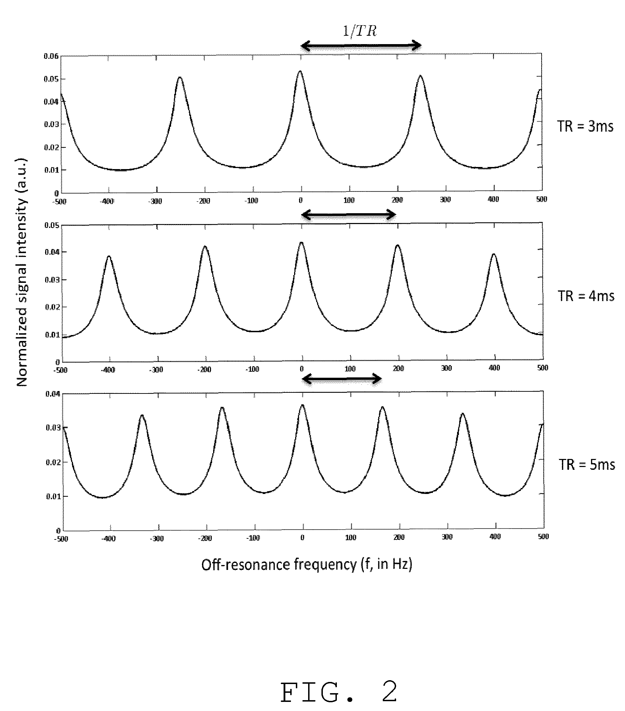

In Fig. 2, in order to resolve the cyclic aliasing of the frequency response, it is proposed to repeat a "Prismatic" acquisition with a different repetition time (TR). Considering the frequency profile of each experiment centered at f=0, the multiple TR experiments allows for each frequency to respond differently during each experiment. The true frequency resolution in "Prismatic" corresponds to the inversion of this relationship between true frequency and "Prismatic"-response.

The resolution of $f_{true}$ corresponds to the inversion of the equation:

$$\begin{bmatrix} f_{bSSFP}(n \in M_1, TR_1) \\ \vdots \\ f_{bSSFP}(n \in M_k, TR_k) \end{bmatrix} = \begin{bmatrix} FSF_{bSSFP}(n \in M_1, TR_1) \\ \vdots \\ FSF_{bSSFP}(n \in M_k, TR_k) \end{bmatrix} * f_{true} \leftrightarrow f_{alias} = A_k * f_{true}$$

where k is the number of acquisitions with different TR values. The vector $f_{alias}$ contains all frequency signals, but with 1/TR aliasing, for one pixel in the image, and the matrix $A_k$ contains all frequency responses for all M frequency-resolved images and for all k acquisitions. Its dimensions are (M*k) x t where t is the number of target true frequencies to resolve.

The solution in each pixel can be found using a least-square approach such as:

$$f_{true} = argmin \, \|f_{alias} - A_k * f_{true}\|_2$$

Due to the constructive nature of interferences created in the "prismatic" MRI according to the invention, the signal received is a combination of both the spectroscopic response from the spins that are excited and the magnetization transfer, or chemical exchange saturation transfer, between the macromolecular spins at excited frequency and the mobile spins from the larger pool, typically water, that receive the magnetization transfer. Therefore, the method according to the invention superimposes both direct nuclear spectroscopy and indirect magnetization transfer imaging. This feature is critical to the quantification of individual spins species.

The method according to the invention, as other bSSFP techniques, is sensitive to the static magnetic field B0 variations, to the dynamic magnetic field B1 inhomogeneity, and to the relaxation parameters T1 and T2 of each species.

B0 variations correspond to a shift of the whole spectrum locally. Embedded B0 correction is achieved according to the invention.

Assuming that the spectral content varies slowly over space so that neighboring pixels share a part of their spectral distribution, the cross-correlation of neighboring pixels is maximized when their B0 shift is negated. That shift in frequency corresponds to the relative B0 difference divided by the gyromagnetic ratio:

$$\Delta f_0(pixel1 \rightarrow pixel2) = \arg\max\left[ xcross\left(f_{true}(pixel1), f_{true}(pixel2)\right) \right]$$
$$= \frac{\Delta B_0(pixel1 \rightarrow pixel2)}{\gamma}$$

Assuming that the B0 field fluctuates slowly over space, the search for the maximum cross-correlation can be restricted to only a few "shifts" between neighboring spectrums. This assumption helps speed up the quantification of $\Delta B_0$ as well as renders the process more robust to noise and divergences from the assumption of spectral similarities. To obtain the absolute B0, the pixels that have a maximum intensity at $f = f_0$ provide a spatial reference point for nominal static field $B = B_0$.

Because the resolution of true frequencies relies on the simulation of FSF, the accuracy of the solution depends on the sensitivity of FSF profiles to simulation parameters that are not controlled by the acquisition: B1, T1 and T2.

One solution is to assume the values of these parameters, which could bias the resolution of the frequency content. Another solution would be resolve for both the FSF and the frequency content. Using multiple definitions of FSF, the minimization of the difference between $A_k * f_{true}$ and $f_{alias}$ can provide both the estimation of the frequency content and its MRI parameters, provided that the resolution of the inverse problem can converge (notably that a sufficient amount of data has been acquired).

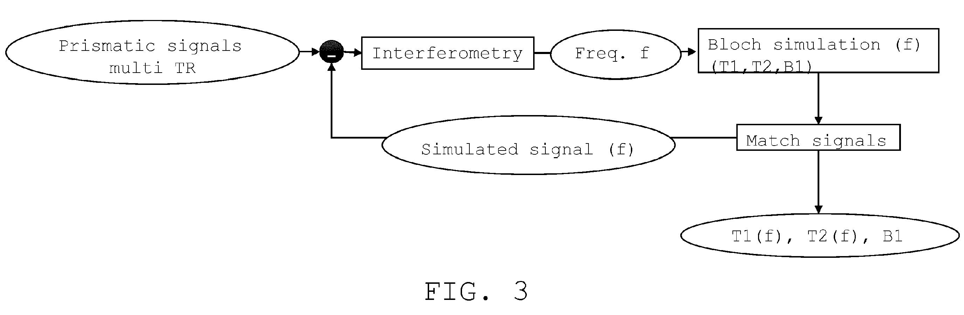

A processing pipeline is proposed in Fig. 3 in which: - the majoritarian true frequency is resolved per pixel by utilizing the different frequency responses of multiple bSSFP experiments with different TR values, this is dubbed interferometry by analogy to optics; - a dictionary of FSF is generated for a range of B1, T1 and T2 values; - the signals from each experiments are matched to the dictionary to estimate B1, T1 and T2 for the frequency determined in the first step; - the matched FSF is scaled to the signals and subtracted to the initial signals; - the process is repeated until a stopping criterion is met, e.g. the remaining signal falls below a given threshold.

EXAMPLE : MRI Acquisitions According to the Method of the Invention

MRI acquisitions were performed on a 3.0 T MRI scanner (Verio, Siemens™, Erlangen, Germany).

A 2D bSSFP sequence was implemented with a quadratic phase increment and a Cartesian k-space sampling with partial Fourier and parallel imaging undersampling supported. Each line of k-space was acquired M times consecutively before stepping to the next k-space line, M being defined as per the invention. A total of M images can thus be reconstructed for each acquisition.

An immediate image reconstruction of all data, without frequency discrimination, was implemented using the Gadgetron™ open source framework for medical image reconstruction, for online quality control.

The true "Prismatic" MRI image reconstruction and processing was performed offline in Matlab™ (Matlab™ R2014b, Mathworks) on an iMac™ Intel™ i5 with 16GB of RAM.

Finally, according to the method of the invention, a dynamic phase variation for which its derivative is M-cyclic according to the equation $\frac{d\phi}{dt}(n + M) = \frac{d\phi}{dt}(n) + \frac{2\pi}{TR}$ implemented with a quadratic phase increment of the excitation pulses is used, that enables bSSFP to sweep the whole spectrum, with 1/TR aliasing, with frequency increments within the same acquisition, and not necessarily between multiple acquisitions. A specific acquisition strategy is thus defined in pair with a corresponding images reconstruction pipeline to provide an image for each frequency (modulo 1/TR) acquired. A post-processing technique, that uses embedded information for the data to measure, allows to resolve the true frequency content per pixel and to correct for magnetic field inhomogeneity and estimate characteristic parameters per frequency population. The entire technique behaves similarly to a prism for MRI as it enables to separate the different colors of the MRI signal, namely the different frequencies.

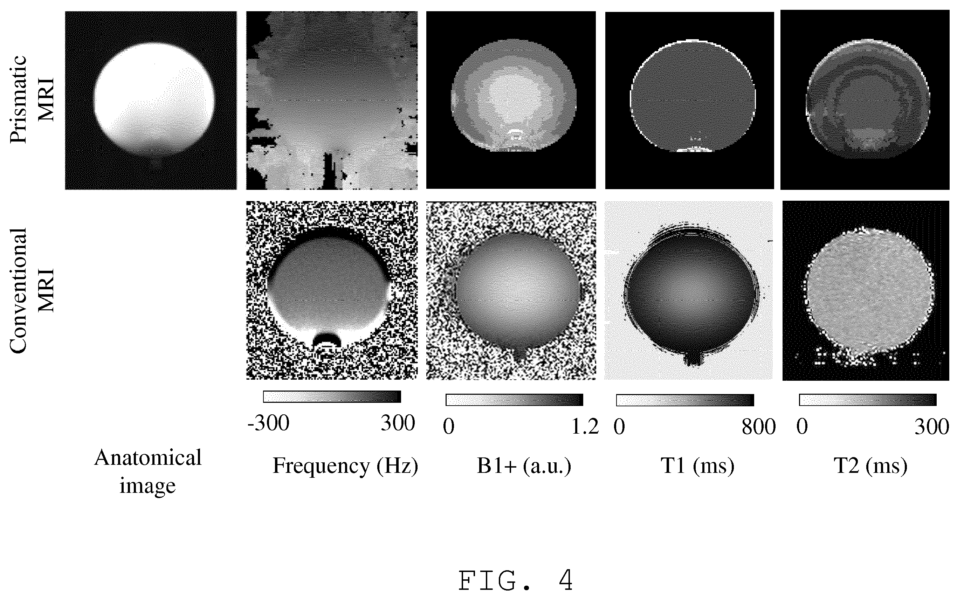

Figure 4 illustrates the results of a 4-TR "Prismatic" MRI experiment. Four bSSFP acquisitions were performed with $\phi_i$ = 2 *deg* (M=90) quadratic phase increments, TR and flip angle values of TR=2.7, 2.9, 3.1 and 3.3ms and $\alpha$ = 30,15, 30 *and* 35 *deg* respectively. TR was incremented using lower pixel bandwidth of 1116, 888, 723, 601 Hz/px. The matrix size was 128x116, the resolution of 2x2x5 mm$^3$, and no undersampling was used. For processing, frequency was resolved over the range -2000Hz to 1000Hz, FSF were simulated for parameters sets of B1 from 0.6 to 1.2, T1 from 300 to 800ms, T2 from 10 to 300ms.

Reference measurements were performed using gold standard techniques: multi echo spoiled gradient echo for B0 mapping, 3D VIBE for T1 mapping and multi-echo spin echo for T2 mapping.

**Claims**

1. A method for obtaining a set of frequency-sensitive balanced steady-state free precession images comprising the steps of:

    providing radio-frequency excitation pulses, wherein the phase of said excitation pulses $\phi_{bSSFP}$ is incremented so that its derivative divided by $2\pi$ is periodic, its fundamental period M is a non-null integer, and its peak-to-peak amplitude is equal to $\dfrac{1}{TR}$, wherein *TR* is the balanced steady-state free precession repetition time;
    acquiring steady-state free precession signals; and
    reconstructing each balanced steady-state free precession image using a combination of k-spaces samples acquired every M repetition time.

2. The method according to claim 1, wherein the radio-frequency excitation pulses are incremented continuously using a quadratic phase increment $\phi_i$, according to the following equation:

$$\phi_{bSSFP}(n) = \phi_i n^2$$

    wherein n is the count number of each balanced steady-state free precession signal during steady-state, and $M = \dfrac{\pi}{\phi_i}$ .

3. The method according to one of the claims 1 or 2, wherein the frequency response in the acquired steady-state free precession signals is varying every repetition time according to the following equation:

$$f_{bSSFP}(n) = \frac{\phi_i n}{\pi TR} \text{ modulo } \frac{1}{TR}$$

    wherein $f_{bSSFP}$ is the central frequency of the frequency response and n is the count number of each balanced steady-state free precession signal during steady-state.

4. The method according to one of the claims 1 to 3, wherein the combination of the k-spaces samples is synchronous so that the precession image is a combination of $\boldsymbol{M} = \dfrac{\pi}{\phi_i}$ images.

5. The method according to one of the claims 1 to 3, wherein the M-scattered sampling of k-spaces provides adequate coverage of k-space, being a synchronous or asynchronous sampling pattern.

6. The method according to one of the previous claims, wherein multiple bSSFP acquisitions with different repetition time are carried out and combined to resolve the entire spectrum.

7. The method according to claim 6, wherein the resolution of the entire spectrum is provided by the following equation:

$$f_{bSSFP}(n, TR) = FSF_{bSSFP}(n, TR) * f_{true}$$

wherein $f_{bSSFP}(n,TR)$ is the $n$ out of M reconstructed frequency images for a given acquisition of TR, $FSF_{bSSFP}(n,TR)$ is the frequency spread function response of the sequence for this given image and $f_{true}$ is the entire frequency content.

8. The method according to claim 7, wherein the entire frequency content $f_{true}$ is resolved using the following equations:

$$\begin{bmatrix} f_{bSSFP}(n \in M_1, TR_1) \\ \vdots \\ f_{bSSFP}(n \in M_k, TR_k) \end{bmatrix} = \begin{bmatrix} FSF_{bSSFP}(n \in M_1, TR_1) \\ \vdots \\ FSF_{bSSFP}(n \in M_k, TR_k) \end{bmatrix} * f_{true}$$
$$\leftrightarrow f_{alias} = A_k * f_{true}$$

wherein k is the number of acquisitions with different TR values. The vector $f_{alias}$ contains all frequency signals, but with 1 /TR aliasing, for one pixel in the image, and the matrix $A_k$ contains all frequency responses for all M frequency-resolved images and for all k acquisitions.

9. The method according to one of the previous claims, wherein the variations of the static magnetic field B0 are corrected.

10. The method according to one of the previous claims, wherein the inhomogeneities in the magnetic field B1 are corrected and the corresponding relaxation parameters T1 and T2 are resolved.

11. A computer-readable medium including a set of instructions for executing the method according to one of the previous claims, by means of an electronic calculator.

FIG. 1

FIG. 2

FIG. 3

Prismatic MRI

Conventional MRI

| | |
|---|---|
| -300 | 300 |

| | |
|---|---|
| 0 | 1.2 |

| | |
|---|---|
| 0 | 800 |

| | |
|---|---|
| 0 | 300 |

Anatomical image

Frequency (Hz)

B1+ (a.u.)

T1 (ms)

T2 (ms)

EP 3 276 368 A1

FIG. 4

Europäisches
Patentamt

European
Patent Office

Office européen
des brevets

# EUROPEAN SEARCH REPORT

Application Number

EP 16 18 1003

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A,D | THOMAS BENKERT ET AL: "Dynamically phase-cycled radial balanced SSFP imaging for efficient banding removal", MAGNETIC RESONANCE IN MEDICINE, 29 January 2014 (2014-01-29), pages n/a-n/a, XP055145292, ISSN: 0740-3194, DOI: 10.1002/mrm.25113 * chapter "Dynamic Phase-Cycling" * | 1-11 | INV. G01R33/561<br><br>ADD. G01R33/48 G01R33/565 G01R33/50 |
| A | BIERL O.: "Spoiled & Balanced Gradient Echo Methods", PROCEEDINGS OF THE INTERNATIONAL SOCIETY FOR MAGNETIC RESONANCE IN MEDICINE, 20TH ANNUAL MEETING & EXHIBITION, 5 May 2012 (2012-05-05), XP040627229, Melbourne, Australia * the whole document * | 1-11 | |
| A | HAN D. ET AL.: "A fast simultaneous water/fat decomposition and T1, T2 quantification method using dual TR bSSFP", PROCEEDINGS OF THE INTERNATIONAL SOCIETY FOR MAGNETIC RESONANCE IN MEDICINE, 23RD ANNUAL MEETING, no. 332, 15 May 2015 (2015-05-15), page 0332, XP040666015, Canada * the whole document * | 1,7,8,10 | TECHNICAL FIELDS SEARCHED (IPC)<br><br>G01R |

-/--

The present search report has been drawn up for all claims

| Place of search | Date of completion of the search | Examiner |
|---|---|---|
| Munich | 26 January 2017 | Skalla, Jörg |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

# EUROPEAN SEARCH REPORT

Application Number

EP 16 18 1003

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | BAMMER R. ET AL.: "Spectrally Sensitive Imaging Using Balanced Steady State Free Precession", PROCEEDINGS OF THE INTERNATIONAL SOCIETY FOR MAGNETIC RESONANCE IN MEDICINE, 14TH MEETING PROCEEDINGS, 6 May 2006 (2006-05-06), page 2630, XP040598147, USA * the whole document * | 1 | |

-----

TECHNICAL FIELDS
SEARCHED      (IPC)

The present search report has been drawn up for all claims

| Place of search | Date of completion of the search | Examiner |
|---|---|---|
| Munich | 26 January 2017 | Skalla, Jörg |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **T. BENKERT et al.** Dynamically Phase-Cycled Radial Balanced SSFP Imaging for Efficient Banding Removal. *Magnetic Resonance in Medicine,* 2015, vol. 73, 182-194